# EUROPÄISCHE PATENTSCHRIFT

(11) **EP 1 738 626 B1**
(45) Veröffentlichungstag und Bekanntmachung des Hinweises auf die Patenterteilung: **25.07.2007**
(21) Anmeldenummer: 05736237.8
(22) Anmeldetag: 18.04.2005
(51) Int. Cl.: H05K 7/14, H05K 1/00, H05K 3/00

(54) **VERFAHREN ZUR BIEGENDEN HERSTELLUNG EINES GERAETS DER LEISTUNGSELEKTRONIK**
PROCESS FOR MANUFACTURING A POWER ELECTRONIC APPLIANCE BY BENDING
PROCEDE DE FABRICATION PAR PLIAGE D'UN APPAREIL DE L'ELECTRONIQUE DE PUISSANCE

(30) Priorität: 19.04.2004 DE 102004018848; 23.09.2004 DE 102004046251
(43) Veröffentlichungstag der Anmeldung: 03.01.2007
(73) Patentinhaber: Lenze Drive Systems GmbH, 31855 Aerzen (DE)
(72) Erfinder: ROHDE, Matthias, 30982 Pattensen (DE); KOLL, Stephan, CH-8200 Schaffhausen (CH)
(74) Vertreter: Leonhard, Frank Reimund
(86) Internationale Anmeldenummer: PCT/DE2005/000704
(87) Internationale Veröffentlichungsnummer: WO 2005/101937

(56) Entgegenhaltungen:
- DE-U1- 20 022 447
- FR-A- 2 714 250
- US-A- 5 179 501

## Beschreibung

Die Erfindung befasst sich mit einem Verfahren zur Herstellung eines Geräts der Leistungselektronik, das mehrseitig geschlossen von einem Gehäuse umgeben ist. Insbesondere ist ein Umrichter angesprochen, der innerhalb des Gehäuses eine Mehrzahl von darin angeordneten Platinen aufweist, die Bauteile aufnehmen (halten) und elektrische Verbindungen zwischen den Bauteilen schaffen. Unter den Bauteilen sind beliebige Bauelemente der elektrischen Antriebstechnik zu verstehen, also sowohl aktive, wie auch passive, wie auch Verbindungsklemmen zum Anschluss von weiterführenden Leitungen.

Die Erfindung beschreibt ein Aufbaukonzept für die genannten Gerätegruppen (Umrichter), durch Biegen von Leiterkarten in Verbindung mit zu biegenden Gehäusewänden als Abschnitte einer zunächst ungebogen oder nur teilweise gebogenen Gehäuseplatte, an der zusätzlich haltende Kunststoffteile angebracht sein könne n, die entweder direkt angespritzt sind oder angeklipst (mechanisch klemmend) daran angebracht werden.

**Die technische Aufgabe** liegt darin, ein kostengünstig zu fertigendes Gerät zu schaffen und das Gehäuse montagefreundlich zu gestalten. Gleichwohl soll das Gerät robust sein, eine sehr gute EMV (Schirmung) zur Verfügung stellen und hohe Funktionsintegration bereitstellen. Unter dieser hohen Funktionsintegration versteht man auch eine optimale Bauraumausnützung, die aber nicht damit einher gehen soll, dass die Zugänglichkeit zu den zu montierenden Leiterkarten (Platinen) erschwert wird, oder aber ihre nachträgliche Reparatur oder Zugänglichkeit unmöglich gemacht ist.

Gelöst wird die Aufgabe mit einem Verfahren, bei dem offen montiert wird, das Gehäuse also noch nicht vollständig geschlossen ist, aber nicht mit später zu montierenden Gehäusedeckeln versehen wird, die anzuschrauben sind, sondern durch einen Biegevorgang das Gehäuse im Anschluss an die offene Montage der zumindest einen oder mehreren schon bestückten Platinen umzuformen, im Wege eines Biegevorgangs. Das Biegen umfasst ein Klappen eines ersten Abschnitts des Gehäuses gegenüber einem ruhenden Abschnitt des Gehäuses, respektive noch der Gehäuseplatte. Das Gehäuse entsteht erst nach ein- oder zweimaligem Abbiegen von Abschnitten der Gehäuseplatte, wobei zusätzlich ein schon vorgebogener Abschnitt vorhanden sein kann, der beim Umbiegen (Klappen) eines Abschnitts der Gehäusewand mitbewegt wird, aber nicht selbst mit umgeformt wird.

Es entsteht ein Gerät nach Anspruch 25 oder 26. Umschrieben durch die Schritte zu seiner Herstellung, die erkennbare Eigenschaften am Gerät selbst hinterlassen.. Das Leistungsgerät enthält die Leiterkarten ebenso wie ihre einhüllende Schale (das Gehäuse).

Der noch im Wesentlichen eben ausgebildete Flächenabschnitt d er gesamten Gehäuseplatte nimmt die Leiterplatte auf, sie wird dabei offen montiert und besitzt selbst, wie auch der im Wesentlichen ebene Abschnitt eine Knick- oder Biegungslinie (auch Schwächungslinie genannt). Entlang dieser parallel verlaufenden Linien von Leiterplatte und Gehäuseplatte erfolgt eine Umformung des Gehäuses, so dass eine weitere im Winkel zum ruhenden Wandabschnitt entstehende Gehäusewand entsteht, bei gleichzeitigem Aufbringen einer Kraft auf die schon montierte Platine, die dabei kräftemäßig so belastet wird, dass die Schwächungslinie der Platine entweder ohne zu brechen knickt oder sogar zum Brechen veranlasst wird und zwei gesonderte Platinen aus der zunächst zusammenhängenden Platine entstehen, die beide aber bereits mit den Gehäusewänden verbunden sind.

Es entsteht eine winklige Form, ggf. auch schon eine mehrfach winklige Form (Anspruch 12), im Zuge der Annäherung zur vollständig geschlossenen Form des Gehäuses an zumindest vier Flächenseiten (Anspruch 15).

Ein weiterer Biegevorgang (Anspruch 13) kann eine weitere Annäherung an den Endzustand der Gehäuseform ergeben, wozu eine weitere parallele Knicklinie im ebenen Abschnitt der Gehäuseplatte vorgesehen ist und auch an dieser Knicklinie umgebogen wird, bevorzugt nach dem ersten Umknicken und Biegen oder Brechen der montierten Platine in zumindest zwei Abschnitte. Im Endzustand ist sowohl durch den ersten Biegevorgang ein Winkel von im Wesentlichen 90° erreicht, und beim zweiten Biegevorgang eine nochmalige winklige Ausbildung von nochmals im Wesentlichen 90°, so dass zwei Abschnitte der zuvor im Wesentlichen eben verlaufenden Gehäusewand dann parallel verlaufen, aber beabstandet sind (Anspruch 14).

Nach zwei aktiven Biegevorgängen, nach Montage der Platine, ergibt erst das an vier Flachseiten geschlossene Gehäuse (Anspruch 15). Nimmt man den einen Vorbiegevorgang hinzu, der den einen zusätzlichen Abschnitt (Anspruch 11) bereits winklig abstehend vorgeknickt hatte, sind drei Biegevorgänge vorgesehen.

Der schon vorgeknickt abstehende Abschnitt kann zur Erleichterung der Montage und Fixierung einer bereits stehend auf der ersten montierten Platine angebrachten und durch Steckkontakte elektrisch verbundenen zweiten Platine dienen, so dass nach dem erstmaligen Biegen und Knicken bzw. Brechen (Anspruch 1, Merkmal (c)) eine in drei Dimensionen liegende Platinenanordnung möglich ist, von denen zwei Platinen übereinander, im Wesentlichen parallel und eine verbindend dazwischen im Wesentlichen senkrecht zu beiden vorhergehenden Platinenabschnitten verläuft.

Damit das Knicken oder auch das Brechen der Platine beim Umformen des Gehäuseabschnitts keine elektrische Unterbrechung erzeugt, kann ein mehradriger Leitungsverbund vorgesehen sein (Anspruch 20), welcher die Schwächungslinie der Platine elektrisch überbrückt und sich bei dem Biegevorgang nachgiebig verhält, also nicht mit-bricht oder seine elektrische Leitfähigkeit verliert.

Das an vier Flachseiten geschlossene Gehäuse bietet hohen EMV-Schutz, ist robust gebaut und stellt Kühlflächen oder zumindest Montageflächen für Kühlkörper zur Verfügung. Es kann metallisch ausgebildet sein, dann ist von einem gebogenen Blech die Rede, das kraft seiner Eigenschaft PE-Verbindung, Schirmauflagen für Steuerleitungen, Gewinde für PE-Anbindungen und direkt Kühlflächen für elektronische Bauelemente zur Verfügung stellt, ebenso wie Wärmeleitung (Anspruch 16). Funktionelle Öffnungen können vorgesehen sein, um Zugriffe zu erleichtern oder Anschlüsse vorzunehmen, die aber nicht verursachen, dass das Gehäuse nicht mehr geschlossen ist. Auch ein mit solchen funktionellen Öffnungen versehenes Gehäuse ist an den vier Flächenseiten im Sinne der Ansprüche 16, 15, 1 mehrseitig geschlossen.

Im Zuge der Blechumkantung oder -biegung erfolgt das Trennen der Leiterkarte bei gleichzeitig bleibender elektrischer Verbindung (Anspruch 2, Anspruch 1). Eine schwimmende Lagerung der Platine erleichtert den Ausgleich beim Biegevorgang (Anspruch 4). Einer der sich ergebenden zwei Platinenabschnitte ist dabei i n seiner Ebene verlagerbar, der andere Platinenabschnitt kann fest montiert sein.

Ebenfalls erleichtert werden kann das Biegen oder der Biegevorgang, der bevorzugt von Hand erfolgt (Anspruch 18), durch eine mechanisch günstige Ausbildung der Schwächungslinie der Platine und/oder des Gehäuses bzw. noch der Gehäuseplatte (Anspruch 6, 8). Die Platine kann im Bereich der Knick- oder Schwächungslinie mehrere beabstandete Ausnehmungen aufweisen, bis hin zu nur noch vorhandenen stegförmigen Verbindungen zwischen den beiden gegeneinander zu knickenden Platinenabschnitten (Anspruch 7). Die zusammenhängende Länge der Knick- oder Schwächungslinie wird dadurch reduziert.

Ebenso kann das Gehäuse eine Knicklinie aufweisen, welche biegekraft-reduziert ist, beispielsweise durch Ausbildung der Knicklinie oder des Bereichs der Knicklinie aus Kunststoff oder einem Kunststoffverbund (Anspruch 9). Ebenso kann aber auch die Länge der Knicklinie bei metallischer Ausbildung reduziert werden, so dass lediglich Stege zu knicken sind, die in ihrer Längsverbindung die genannte Linie (Knick- oder Biegelinie) definieren.

Ein mehrfaches Knicken, also ein schließendes Umbiegen und ein öffnendes Rückbiegen hinsichtlich der zu biegenden Gehäuseplatte ist damit erlaubt, führt nicht zum Brechen der Biegelinie (oder der sie definierenden Stege) und kann Wartungsarbeiten ermöglichen (Anspruch 10). Eine andere Möglichkeit de r Kräftereduzierung ist die Ausbildung der Gehäuseplatte aus einem Kunststoff oder Kunststoffverbund, insbesondere mit einer außen liegenden Metallbeschichtung (Anspruch 17). Der Kunststoff ist biegefähig, erlaubt ein Knicken an der Knicklinie, ohne dort zu brechen, ist aber im übrigen steif genug, um Gehäusefunktion ausüben zu können.

Zur Verbesserung der Isolation und zur Erreichung höherer Spannungsfestigkeiten und höherem IP-Schutz kann eine flächige Kunststofflage zwischen die offen montierte Leiterkarte und die darunter liegende Gehäuseplatte dazwischengelegt werden (Anspruch 5). Diese Isolierlage erlaubt es, die Platine näher an das metallische Gehäuse zu bringen und damit kompakter aufzubauen.

Bei der Montage der Platine ist diese im Wesentlichen eben (Anspruch 3); das Gehäuse ist auch im Wesentlichen eben, kann aber eine Knickstelle bereits aufweisen (Vorknickung, Anspruch 11) oder einen winkelförmigen Abschnitt (Anspruch 21) bereits aufweisen, der die Knicklinie enthält (Anspruch 22), welche unter der Platine liegt. Der "im Wesentlichen eben" ausgebildete Gehäuseplattenabschnitt bleibt trotz dieses Winkelstücks im Sinne des Merkmals (a) des Anspruchs 1 weiterhin im Wesentlichen eben.

Im fertigen Zustand sind die Biegewinkel der gegeneinander umgebogenen (geklappten) Flächenabschnitte der Gehäuseplatte im Wesentlichen rechtwinklig (Anspruch 2) zur ruhenden Wand, aber erst gegen Ende des jeweiligen Biegevorgangs.

Im geschlossenen Gehäuse, am Ende aller Biegevorgänge, ist eine optimierte Leiterplattennutzung über eine 3D-Leiterbahnführung gegeben. Gleichzeitig kann eine Isolierung über die Kunststoffelemente und Kunststoffflächen zum gebogenen Blech erhalten werden.

Ausführungs**beispiele** erläutern und ergänzen die beanspruchte Erfindung.
- **Figur 1**: ist ein offenes Gehäuse G, noch ohne eingelegte Leiterplatte, mit drei Abschnitten 10a, 10b und 10c und mit einem bereits (recht-) winklig abstehenden vierten Abschnitt 10d.
- **Figur 2**: ist ein nach mehreren Biegevorgängen geschlossenes Gehäuse G*, ohne darin eingelegte Leiterkarten (oder -platten).
- **Figur 3a, Figur 3b, Figur 3c, Figur 3d**: veranschaulichen den Biegevorgang von Gehäuse und Leiterkarte (oder -platte).
- **Figur 3e**: Ausschnitt aus Figur 3c (links unten) nochmals und vergrößert.
- **Figur 4**: veranschaulicht das gebogene Gehäuse entsprechend der Figur 2, hier mit innen liegender 3D-Leiterbahnführung auf Leiterkarten und einem Klemmenanschluss 61 für das Anschließen von zuführenden und abführenden Leitungen (die nicht dargestellt sind).
- **Figur 5**: veranschaulicht ein Detail des Biegevorgangs, teilweise im Schnitt.
- **Figur 6**: veranschaulicht eine alternative Ausgestaltung des Biegebereichs von Platine 30 und Gehäuseplatte G.

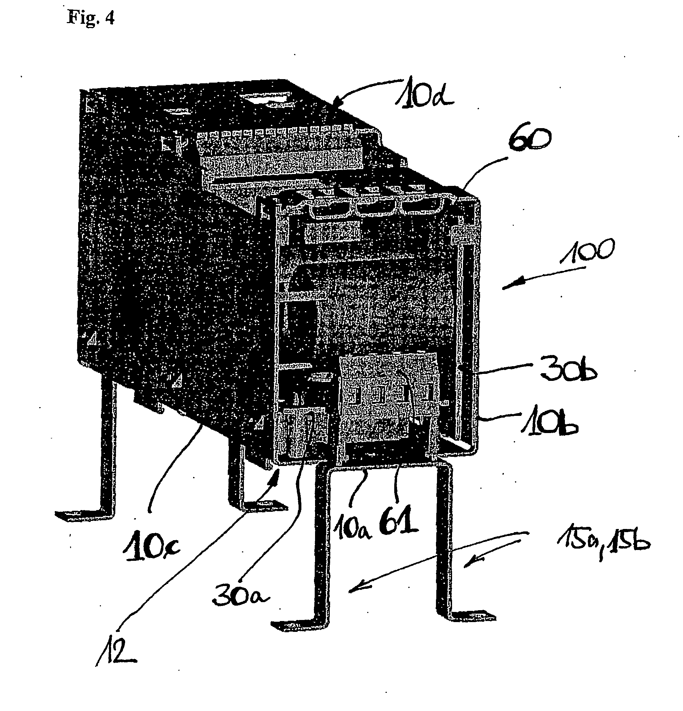

Das Herstellverfahren zur Herstellung eines mehrseitig geschlossenen Gehäuses ist im Verfahrensergebnis in der **Figur 4** verdeutlicht. Das Gehäuse hat vier Flachseiten, die teilweise mit funktionalen Öffnungen versehen sind, so Öffnung 19a (oberseitig) und eine in Figur 4 nicht sichtbare untere Öffnung 19 zur Montage, zum Durchgriff oder zur Durchführung von Leitungen. Diese Durchbrüche durch das Gehäuse beeinträchtigen nicht die Bedeutung der "mehrseitig geschlossenen Gehäuseform", die sich auf die wesentlichen Flächenabschnitte des Schließens bezieht.

In der Ausführung nach Figur 4 ist ein Gerät 100 der Leistungselektronik von dem Gehäuse umschlossen und die das Gerät ausmachende Elektronik ist im Inneren, in dreidimensionalem Aufbau. Ersichtlich sind passive Bauteile, wie Kondensatoren 60 oder Klemmenanschlüsse 61 oder Trafos 62, wobei die Kondensatoren von der einen Seite auf einer Platine 30b gelötet sind und von der anderen Flachseite 10c mit Stegen mechanisch gehalten werden.

Das im Beispiel als Umrichter (Frequenzumrichter) ausgebildete Gerät der Leistungselektronik steht auf vier Füßen, die abgewinkelt ausgebildet sind, zwei vordere Füße 15a, 15b und zwei hintere Füße. Zwischen diesen Füßen können Kühlkörper mit ihrer Flachseite nach oben an der unten liegenden Platte 10a (untere schmale Flachseite) thermisch leitend angekoppelt werden. Der Anschluss von Maschinen oder Motoren kann über die Klemmen 61 erfolgen.

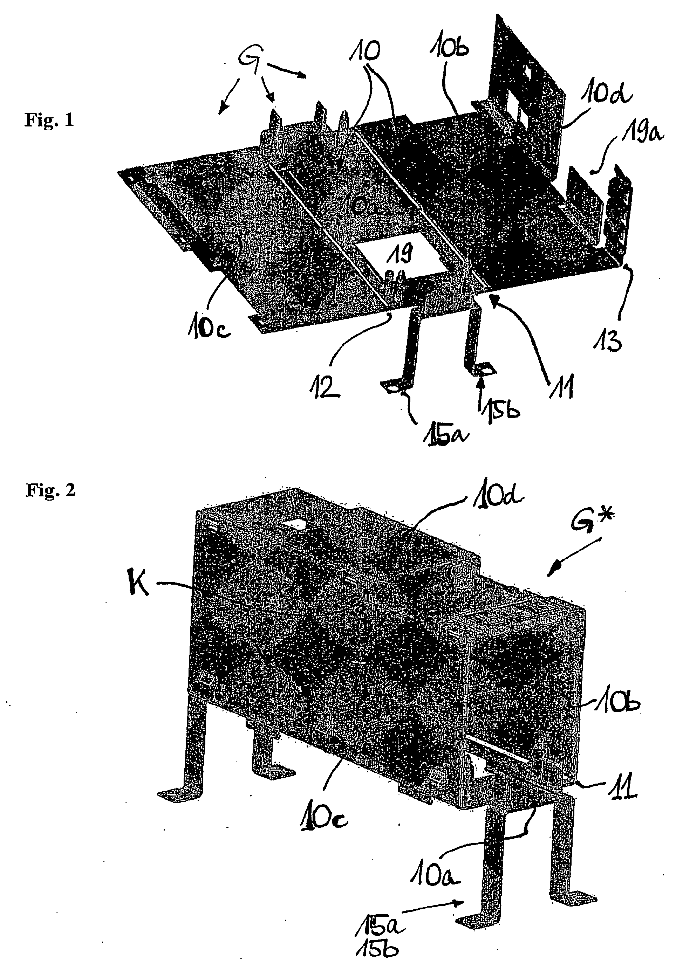

Der Aufbau des Umrichters nach Figur 4 wird anhand der anderen **Figuren 1 bis 3** näher erläutert.

In einer offenen Montage wird eine Leiterplatte 30, die bereits mit Bauelementen bestückt ist, auf einen im Wesentlichen ebenen Flächenabschnitt einer Gehäuseplatte G montiert, wozu in Figur 1 zunächst die Gehäuseplatte mit all ihren Abschnitten dargestellt ist, mit der man nach mehreren Biegevorgängen zum Gehäuse nach Figur 4 kommt. Die Leiterplatte ist weggelassen, sie wird auf den in Figur 1 ersichtlichen Stützfüßen aufgelegt und befestigt. Die eine flächige Schmalseite 10a ist flankiert von zwei breiten Flächenseiten 10c und 10b, wobei am rechten Rand der Flächenseite 10b ein bereits nach oben winklig vor-gebogener Abschnitt 10d als weitere schmale Flächenseite angebracht ist. Zwischen den einzelnen Wandabschnitten finden sich Biegelinien 12, 11, 13, welche durch nicht durchgehend verlaufende (kurze) Stegabschnitte gebildet werden, an denen eine Biegung oder Knickung erfolg en kann, ohne dass die Stege oder die Knicklinie bricht.

Die geschwächten Abschnitte, mithin alle Stege, verbinden sich zu jeweils ein er gedachten Biegelinie, wobei die drei gezeichneten Biegelinien 12, 11 und 13 parallel zueinander verlaufen.

Die offene Montage ist ersichtlich so gestaltet, dass eine Platine mit vormontierten Baueinheiten auf einen flächigen Abschnitt 10a, 10b aufgelegt wird und dabei eine der Biege- oder Knicklinien, hier die Knicklinie 11, überbrückt bzw. über ihr zu liegen kommt.

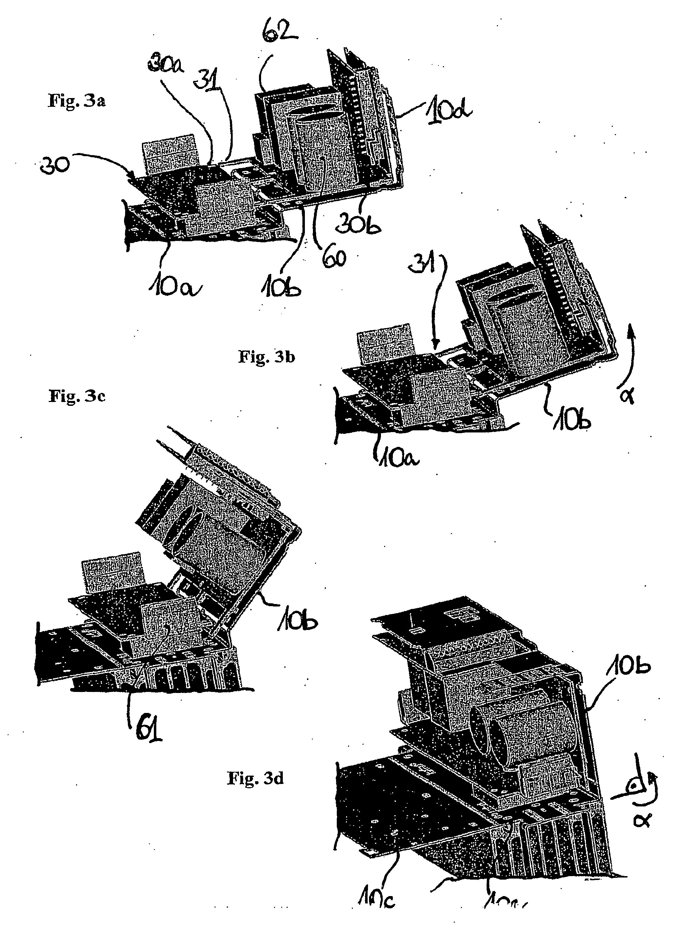

Dieser im Wesentlichen ebene Flächenabschnitt 10a, 10b des Gesamtgehäuses G im noch nicht vollständig gefalteten (umgebogenen) Zustand, verläuft im Wesentlichen parallel zu der aufgelegten Leiterkarte, die in Figur 3a im aufgelegten Zustand ersichtlich ist.

Auch die Leiterplatte besitzt eine Knick- oder Schwächungslinie 31, welche zwei funktionale Platinenabschnitte 30a und 30b bildet, welche durch die Schwächungslinie 31 entlang der Längsrichtung der Platine 30 definiert werden. Auch diese Schwächungslinie 31 verläuft parallel zu der Knick- oder Biegelinie 11 in dem im Wesentlichen ebenen Flächenabschnitt der Gehäuseplatte G.

Die Gehäuseplatte G wird in einem ersten Verfahrensschritt des Verfahrens an der Knicklinie 11 zu einer sich langsam aufbiegenden, bis hin zur rechtwinklig orientierten Form gebogen. Dieser Biegevorgang ist in Figur 3b verdeutlicht, wobei der Flächenabschnitt 10b gegenüber dem Flächenabschnitt 10a der Gehäuseplatte um den Winkel α hochgebogen wird, unter Belastung der Knicklinie 11 zwischen den beiden Abschnitten 10a und 10b der Gehäuseplatte.

Durch die Knickung des Gehäuses, die von Hand erfolgen kann, wird eine Biegekraft (auch Knickkraft) auf die montierte Platine 30 aufgebracht und hier besonders auf deren Schwächungslinie 31. Die Platine wird an dieser Schwächungslinie abknicken oder sogar abbrechen, um die zwei dann eigenständig werdenden Platinenabschnitte 30a und 30b gegeneinander winklig auszubilden, wobei der Platinenabschnitt 30b im Winkel α (alpha) hoch geschwenkt wird, bis zum Erreichen eines im Wesentlichen rechtwinkligen Zustands, gegenüber dem verbleibenden Platinenabschnitt 30a an der schmalen Flachseite 10a des Gehäuses. Bricht die Platine an der Schwächungslinie 31 , so wird ein elektrischer Kontakt durch zumindest einen mehradrigen Leitungsverbund 35 hergestellt, der die Schwächungslinie 31 überbrückt und beide entstehenden Einzelplatinen 30a und 30b elektrisch miteinander verbindet, ohne.dass weitere Eingriffe erfolgen müssen.

Biegt sich die Platine lediglich an der Knicklinie um und behält ihre physische Verbindung bei, können andere Leiterbahnen auch eine elektrische Kontaktierung übernehmen.

Die Figur 3c verdeutlicht den abgebrochenen Zustand, bei dem die Schwächungslinie zwischen den beiden Platinenabschnitten 30a, 30b gebrochen ist, bei einer weiter erfolgenden Aufwärtsbewegung der Wand 10b bis zum Erreichen eines im Wesentlichen rechtwinkligen Zustands gegenüber dem Wandabschnitt 10a.

Die mitbewegte, schon vor-gebogene Wand 10d verläuft dann parallel zur nicht mit umgeformten Wand 10a.

In einem weiteren Biegeprozess, der nicht gesondert dargestellt ist, wird die verbliebene Wand 10c auch um 90° aufwärts gebogen, so dass sie im Wesentlichen parallel zur Wand 10b verläuft. Die Gehäuseform der Figur 4 ist erreicht.

An den Nahtstellen oder den Kanten können Kunststoffteile zum rastenden Verbinden vorgesehen sein. Beispiele für dieses klemmende oder rastende Verbinden sind in Figur 2 zu erkennen, dort mit K bezeichnet. Zur Verdeutlichung sind hier die Platinen im Inneren des vollständig umgeformten Gehäuseaufbaus 10c, 10a, 10b und 10d weggelassen.

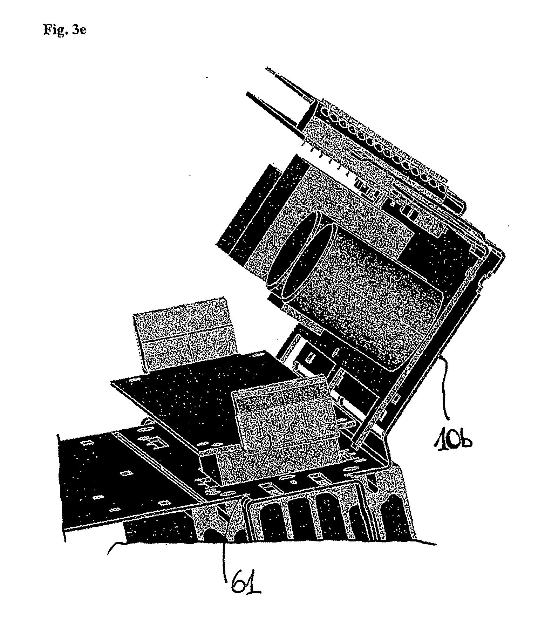

Zur Reduzierung der entstehenden Biegekräfte oder der von Hand aufzuwendenden Knickkräfte an den Biegelinien von einerseits Gehäuse und andererseits Platine, können beide Bieglinien kräfte-reduziert ausgebildet werden. Diese Reduzierung der Kräfte erfolgt durch Einbringen von Ausnehmungen, so dass nur Stege verbleiben, welche entlang einer Linie verbundenen die Knicklinie (auch: Biegelinie) definieren. Die beabstandeten Ausnehmungen sind in der Länge wesentlich größer, als die verbliebenen Steg, wie bei der Biegelinie 12 und 11 an der Figur 1 (hinsichtlich des Gehäuses) und bei der Schwächungslinie 31 in der Platine (bei Figuren 3) ersichtlich. Es sind lediglich Stege verblieben, die relativ kurze, entlang der Biegelinie verlaufende Breiten besitzen, um die Brech- oder Biegekräfte möglichst gering auszugestalten.

Als Biegestellen bei der Platine empfehlen sich auch tiefengefräste Ausbildungen.

Zur Verbesserung der Isolationsfestigkeit kann eine Isolierlage 20 auf die Gehäuseplatte aufgelegt werden, bevor die Platine 30 aufgelegt wird. Abstände, welche die Platine dann vom Gehäuse noch haben muss, können so reduziert und Bauraum eingespart werden. Zum besseren Aufnehmen von entstehenden Ausgleichsbewegungen, kann die Platine bei ihrer Montage schwimmend gelagert montiert werden. Damit können Toleranzen ausgeglichen werden oder notwendige Verschiebebewegungen eines Abschnitts der Platine bei Biegebeanspruchung als Folge der Biegung der Gehäuseplatte erlaubt werden.

Die Gehäuseplatte ist bevorzugt metallisch. Das so gebildete Blech hat eine verbesserte EMV bzw. ein diesbezüglich verbessertes Verhalten und bietet eine robuste Bauweise. Die Ausbildung aus Kunststoff als Platte ist aber ebenfalls möglich, dieser Kunststoff kann dann metallisch beschichtet werden. Bevorzugt die Bereiche der Knicklinien können aus Metall oder Kunststoff ausgebildet werden, um eine mehrfache Hin- und Zurückbiegung an der Knicklinie zu erlauben und das Gehäuse auch ohne Brechen der Biegelinie wieder öffnen zu können, und zusätzlich erneut auch verschließen zu können.

Wird eine Metallbeschichtung gewählt, ist sie bevorzugt außen anzubringen; der biegesteife Kunststoff als Gehäuseplatte muss in der Lage sein, die mechanische Belastung eines Gehäuses aufzunehmen, und gleichzeitig an den Knicklinien biegefähig sein, ohne zu brechen.

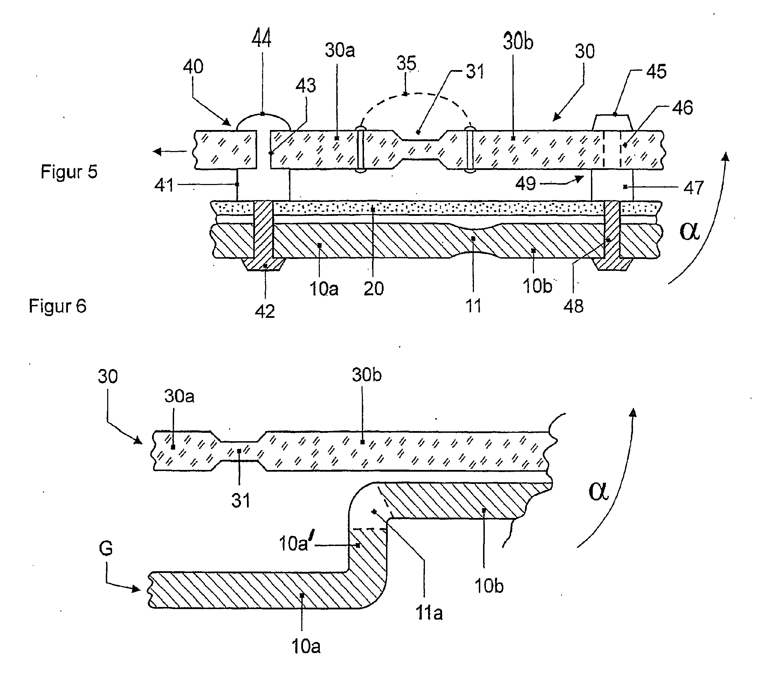

An der Gehäuseplatte können eine Vielzahl von angespritzten Kunststoffteilen vorgesehen sein, die entweder flächig oder stabförmig sind, zum Isolieren (von Nestern oder gesamten Flächen) und zum Aufnehmen von Bauteilen oder zum Halten von Bauteilen im Sinne von Befestigungsstegen. Zusätzlich können die angespritzten Kunststoffteile auch zur Platinenführung vorgesehen sein, hier insbesondere auch zur schwimmenden Lagerung der Platine oder zum festen Halten der nicht beweglichen Platinen auf dem aufwärts gebogenen Abschnitt 10b des Gehäuses. Angespritzte Isolierflächen entsprechen den eingelegten Isolierfolien 20 von **Figur 5**, nur direkt an der Gehäusewand angespritzt, Halteteile zum Halten von Bauteilen entsprechen denen in Figur 1 auf den Wandabschnitten 10a und 10c ersichtlichen Stegen, wie auch die in Figur 4 zum Halten des Kondensators 60 vorgesehenen Stege, oder nicht gesondert dargestellte bewegliche Kunststoffteile oder Stege, zur Veränderung ihrer Lage und zum Lösen und Halten von Bauteilen oder Wandabschnitten.

Zwei Detailansichten der **Figuren 5 und 6** sind teilweise im Schnitt Ausschnitte aus einem Bereich zwischen Platine und Gehäuseplatte im Bereich der Schwächungslinie 31 der Platine 30 und der Knick- oder Biegelinie 11 der Gehäusewand. Die übrigen Bereiche sind in den Figuren 5 und 6 nicht dargestellt.

Eine Ausführung ist gegeben durch eine Platine 30, die einen geschwächten Streifen 31 besitzt, der sie längs in zwei Abschnitte 30a und 30b unterteilt, die aber zunächst zusammenhängend, wie Figur 5 im noch nicht geknickten Zustand des flächigen Abschnitts 10a, 10b des Gehäuses zeigt. Eine Isolierlage 20 liegt auf dem metallisch ausgebildeten Gehäuse aus Abschnitt 10a, Knicklinie 11 und flächigen Abschnitt 10b auf. Es wird gehalten von Stützstellen 40, 49.

Die Stützstelle 49 ist durch eine Öffnung der Wand fest mit dieser Wand über den spritzgeformtem Kopf 48 verbunden, bietet eine Auflage 47 für die Platine und greift mit einem Durchgriffsstück 46 als oberer Schaft durch die Platine, um von oben mit einem Kopf 45 die mechanische Fixierung der Platine zu erreichen. An der anderen Stelle, jenseits der Schwächungslinie 31 ist eine schwimmende Lagerung 40 vorgesehen, die ein seitliches Führen durch einen Stegabschnitt 43, einen übergreifenden Kopf 44 und eine Auflage 41 besitzt, zum lateralen Führen der Platine un d schwimmenden Lagern. Das schwimmend lagernde Haltestück 40 ist ebenfalls mit ei nem Durchgriff durch die Wand 10a an dieser mit spritzgeformtem Kopf 42 festgelegt.

Die Platine 30 wird im über die Schwächungslinie 31 mit einer leitenden Verbindung, die aus einem Bündel von mehreren Leitungen, insbesondere einer Flachlitze aus einer Vielzahl von parallelen Leitungen, die gegeneinander isoliert sind, besteht.

Wird das Gehäuse entlang des Winkels α aufwärts gebogen, verändert sich die Winkellage der Gehäuseabschnitte 10a und 10b. Die Knick- und Biegelinie 11 bietet die Möglichkeit, die Kräfte von Hand aufzubringen und durch die aufgebrachten Biegekräfte wird - übertragen durch die Stützstelle 49 und durch das Begrenzen der Aufwärtsbewegung durch den Kopf 44 des anderen Halters die Biegekraft auf die Schwächungsstelle 31 der Platine 30 übertragen. Sie bricht an dieser Stelle 31 entweder durch oder knickt an dieser Stelle, so dass sich die beiden Gehäuseabschnitte 30a und 30b bis hin zur Rechtwinkligkeit aufbiegen können. Entsprechend rechtwinklig sind dann auch die Abschnitte 30a und 30b der Platine 30 ausgebildet, bei einer Ausgleichsbewegung des linken Abschnitts 30a der Platine, erlaubt durch die schwimmende Lagerung 40.

In einer alternativen Ausführung nach **Figur 6**, die derjenigen in der Figur 3 entspricht, ist der im Wesentlichen flache Abschnitt 10a, 10b des Gehäuses mit einer stufigen- oder z-förmigen Winkelstelle 10a' versehen, welche die beiden ebenen Abschnitte 10a und 10b parallel versetzt, aber noch immer gemeinsam im Wesentlichen flach verlaufen lässt. Am oberen Ende des Winkelstücks 10a' ist die Knick- und Biegelinie 11a ausgebildet, zum Aufbiegen entlang des Winkels α, und zwar sowohl des Gehäuseabschnitts 10b, wie zeitgleich und gemeinsam auch des rechten Abschnitts 30b der Platine 30.

Die Schwächungslinie 31 wird auch hier biegen oder brechen.

Die elektrisch überbrückende Flachlitze 35 nach Figur 5 kann hier ebenfalls eingesetzt werden.

Der Abstand des verbleibenden, nicht mit gebogenen Platinenabschnitts 30a von der schmalen Flachseite 10a des Gehäuses bleibt gleich und ist deutlich größer, als der Abstand der zweiten Platinenhälfte 30b von der aufwärts gebogenen Gehäusewand 10b. Durch Isolierlagen kann die Spannungsfestigkeit zwischen 30b und 10b verbessert oder erhöht werden. Die Anordnung der Knicklinie 11 a ist bevorzugt am oberen Ende des Winkelstücks 10a' vorgesehen.

Zumindest zwei Biegungen, ausgehend von dem Zustand nach Figur 1, sind erforderlich, das fertige Gehäuse nach Figur 4 mit in diesem Gehäuse liegenden dreidimensionalen Platinen- und Schaltungsaufbau zu erreichen. Nimmt man die Vorbiegung entlang der Knicklinie 13 noch hinzu, sind es insgesamt drei Biegevorgänge.

Ein Rückbiegen ist aufgrund der Ausgestaltung der Biegelinien ohne weiteres möglich. Das Gehäuse kann auch ohne Schraubbefestigungen zuverlässig geöffnet werden; die Verbindungsstücke K an der Nahtkante (links oben in Figur 4) können mehrfach geöffnet und geschlossen werden.

## Patentansprüche

1. **Verfahren** zur Herstellung eines mehrseitig geschlossenen Gehäuses als Gerät (100) der Leistungselektronik, insbesondere eines Umrichters, mit darin angeordneten Platinen (30;30a,30b) für das Halten und elektrische Verbinden von darauf angeordneten Bauelementen (60,61,62), wobei
(a) in einer offenen Montage auf einem im Wesentlichen ebenen Flächenabschnitt (10a,10b,10c,10a') einer Gehäuseplatte (G,10) eine bereits mit Bauelementen bestückte Leiterplatte (30) montiert wird;
(b) die Leiterplatte zumindest eine Knick- oder Schwächungslinie (31) aufweist, welche parallel verläuft zu einer Knicklinie (11) in dem im Wesentlichen ebenen Flächenabschnitt der Gehäuseplatte;
(c) die Gehäuseplatte (G,10) an der Knicklinie (11) zu einer winkligen Form (10a,10b) umgebogen wird und dabei die Knick- oder Schwächungslinie (31) der Platine ebenfalls mit Knick- oder Biegekräften belastet wird,
zum Umbiegen der Platine (30) und ihrem Brechen in zwei winklig zueinander orientierte Platinenstücke (30a,30b).

2. Verfahren nach Anspruch 1, wobei die winklige Form im Wesentlichen rechtwinklig ist (10a, 10b), am Ende des Biegevorgangs.

3. Verfahren nach Anspruch 1, wobei die Platine (30) bei ihrer Montage auf dem im Wesentlichen ebenen Flächenabschnitt der Gehäuseplatte (G) eben und ungeteilt ausgebildet ist.

4. Verfahren nach Anspruch 1, wobei die Platine (30) bei ihrer Montage auf dem im Wesentlichen ebenen Abschnitt schwimmend gelagert montiert wird (40;41 bis 44), zum Ausgleich von Toleranzen oder Folgen der Biegebeanspruchung.

5. Verfahren nach Anspruch 1, wobei zwischen der Platine (30) und der Gehäuseplatte (10, G) eine Isolierlage (20) zwischengelegt wird.

6. Verfahren nach Anspruch 1, wobei die Knick- oder Schwächungslinie (31) der Platine kräfte-reduziert ausgebildet ist.

7. Verfahren nach Anspruch 6, wobei die Platine (30) im Bereich der Knick- oder Schwächungslinie mehrere beabstandete Ausnehmungen aufweist, zur Reduzierung der zusammenhängenden Länge der Knick- oder Schwächungslinie (31).

8. Verfahren nach Anspruch 1, wobei die Knicklinie im ebenen Abschnitt biegekraft-reduziert ausgebildet ist.

9. Verfahren nach Anspruch 8 oder 1, wobei die Knicklinie (11) der Gehäuseplatte (G) aus Metall oder Kunststoff ausgebildet ist.

10. Verfahren nach Anspruch 1 oder 9, wobei die Gehäuseplatte (G) mehrfach knickbar ist, an mehreren, im Wesentlichen parallel verlaufenden Knicklinien (11,12).

11. Verfahren nach Anspruch 1, wobei ein Abschnitt (10d) der Gehäuseplatte bereits winklig abstehend vorgeknickt ist, bei der Montage der Leiterplatte (30) auf den im Wesentlichen ebenen Abschnitt, welche Vorknickung um eine Knicklinie (13) zwischen dem ebenen Abschnitt (10a,10a',10b,10c) und dem winklig abstehenden Abschnitt (10d) verläuft.

12. Verfahren nach Anspruch 1, wobei mit dem Knicken von Platine und ebenem Abschnitt der Gehäuseplatte der winklig abstehende Abschnitt (10d) mitbewegt, aber nicht zusätzlich umgeformt wird.

13. Verfahren nach Anspruch 1, 11 oder 12, wobei in dem ebenen Flächenabschnitt eine weitere, parallel verlaufende Knicklinie (12) angeordnet ist, und die Gehäuseplatte auch um diese weitere Knicklinie (12) umgebogen wird, zum winkligen Umformen eines weiteren Abschnitts (10c) des ebenen Flächenabschnitts (10a, 10a', 10b, 10c) der Gehäuseplatte (G), insbesondere nach dem Umformen gemäß Merkmal (c) des Anspruchs 1.

14. Verfahren nach Anspruch 13, wobei beide umgebogenen Abschnitte (10b, 10c) des im Wesentlichen ebenen Flächenabschnitts nach den beiden Umbiegungen im Wesentlichen parallel zueinander verlaufen, aber beabstandet sind.

15. Verfahren nach Anspruch 1, 13, 14 und 11, wobei nach den Knick- und Biegevorgängen das Gehäuse (100) an zumindest vier Flächenseiten geschlossen ist, insbesondere nach nicht mehr als drei der genannten Knick- und Biegevorgängen.

16. Verfahren nach Anspruch 1 oder 15, wobei die Gehäuseplatte (G) im Wesentlichen vollständig aus metallischem Blech ausgebildet ist, insbesondere funktionelle Öffnungen (19, 19a) aufweist.

17. Verfahren nach Anspruch 1, wobei die Gehäuseplatte (G) aus steifem, aber an den Knicklinien (11, 12, 13) biegefähigem Kunststoff besteht, und mit einer insbesondere nach außen weisenden Metallbeschichtung belegt ist.

18. Verfahren nach Anspruch 1, wobei das Biegen der Gehäuseplatte (G, 10) und das daraus folgende kräftemäßige Belasten der Platine an der Schwächungslinie (31) von Hand erfolgen.

19. Verfahren nach einem der vorherigen Ansprüche, wobei von der Gehäuseplatte (G) angespritzte Kunststoffteile abstehen, insbesondere Halterteile für Bauteile, Verbindungsstücke (K) zur Verbindung von umgebogenen (geklappten) Abschnitten der Gehäuseplatte, Isolierstücke oder solche Flächen oder bewegliche Kunststoffelemente zur Fixierung von Bauteilen.

20. Verfahren nach Anspruch 1, wobei die Knick- oder Schwächungslinie (31) der Platine von einem mehradrigen Leitungsverbund (35) elektrisch leitend überbrückt ist, der nachgiebig ausgebildet ist.

21. Verfahren nach Anspruch 1, wobei der im Wesentlichen ebene Flächenabschnitt der Gehäuseplatte ein Winkelstück (10a') aufweist und dieses Winkelstück zwei ebene Flächenabschnitte (10a, 10b) der Gehäuseplatte verbindet.

22. Verfahren nach Anspruch 21, wobei in dem Winkelstück die Knicklinie (11) der Gehäuseplatte angeordnet ist.

23. Verfahren nach Anspruch 1, wobei die Knick- oder Schwächungslinie (31) der Leiterplatte von kurzen Stegabschnitten festgelegt wird, welche wesentlich kürzer sind als die Länge der Schwächungslinie.

24. Verfahren nach Anspruch 1, wobei die Knicklinie (11) in dem im Wesentlichen ebenen Flächenabschnitt (10a, 10b) der Gehäuseplatte von kurzen Stegabschnitten festgelegt wird, welche wesentlich kürzer als die Länge der Schwächungslinie sind.

25. **Mehrseitig geschlossenes Gehäuse** mit darin angeordneten Platinen (30;30a,30b) für ein Halten und elektrisch leitendes Verbinden von darauf angeordneten Bauelementen (60,61,62), als ein Gerät (100) der Leistungselektronik, insbesondere als ein Umrichter, **hergestellt oder herstellbar** nach zumindest einem Verfahren der vorigen Ansprüche, wobei
(a) in einer offenen Montage auf einem im Wesentlichen ebenen Flächenabschnitt (10a,10b,10c,10a') einer Gehäuseplatte (G,10) eine bereits mit Bauelementen bestückte Leiterplatte (30) montiert wird;
(b) die Leiterplatte zumindest eine Schwächungslinie (31) aufweist, welche parallel verläuft zu einer Knicklinie (11) in dem im Wesentlichen ebenen Flächenabschnitt der Gehäuseplatte;
(c) die Gehäuseplatte (G,1 0) an der Knicklinie (11) zu einer winkligen Form (10a,10b) umgebogen wird und dabei die Schwächungslinie (31) der Platine ebenfalls mit Biegekräften belastet wird,
unter Umbiegen und Brechen der Platine (30) in zwei winklig zueinander orientierte Platinenstücke (30a,30b) und Ausbilden des Geräts (100) der Leistungselektronik.

26. Mehrseitig geschlossenes Gehäuses mit darin angeordneten Platinen (30;30a,30b) nach Anspruch 25, mit mehreren der genannten Knicklinien (11) und Schwächungslinien, die jeweils paarweise einander zugeordnet sind oder werden oder waren.

## Claims

1. **A method** of producing a power electronics device (100), especially a converter, in the form of a casing closed on a number of sides and containing printed circuit boards (30; 30a, 30b) for holding and electrically connecting components (60, 61, 62) mounted on it, wherein
(a) a circuit board (30) already fitted with components is mounted in an open assembly on a substantially flat surface portion (10a, 10b, 10c, 10a') of a plate or side (G, 10) of the casing;
(b) the circuit board has at least one buckling or weakening line (31) parallel with a buckling line (11) in the substantially flat surface portion of the plate;
(c) at the buckling line (11) the plate (G, 10) is bent into an angular shape (10a, 10b), when the buckling or weakening line (31) of the circuit board is also subjected to buckling or bending forces,
in order to bend the circuit board (30) and break it into two pieces (30a, 30b) at an angle to one another.

2. A method according to claim 1 , wherein the angular shape is substantially rectangular (10a, 10b) at the end of the bending process.

3. A method according to claim 1, wherein the circuit board (30) is flat and non-divided when mounted on the substantially flat surface portion of the plate (G).

4. A method according to claim 1, wherein the circuit board (30), when mounted on the substantially flat portion, is float-mounted (40; 41 to 44) in order to compensate for tolerances or the results of the bending stress.

5. A method according to claim 1, wherein an insulating layer (20) is inserted between the circuit board (30) and the plate (10, G).

6. A method according to claim 1, wherein the buckling or weakening line (31) of the plate is made so as to reduce the required bending forces.

7. A method according to claim 6, wherein the circuit board (30) has a number of spaced-apart recesses in the neighbourhood of the buckling or weakening line in order to reduce the continuous length of the said line (31).

8. A method according to claim 1, wherein the bending force required along the buckling line in the flat portion is reduced.

9. A method according to claim 8 or 1, wherein the buckling line (11) in the plate (G) is made of metal or plastics material.

10. A method according to claim 1 or 9, wherein the plate (G) can buckle at a number of places along a number of substantially parallel lines (11, 12).

11. A method according to claim 1, wherein a portion (10d) of the plate is already buckled and projects at an angle when the circuit board (30) is fitted on to the substantially flat portion, the preliminary buckling occurring around a line (13) between the flat portion (10a, 10a', 10b, 10c) and the portion (10d) projecting at an angle.

12. A method according to claim 1 , wherein the portion (10d) projecting at an angle is moved but not additionally bent when the circuit board and the flat portion of the plate buckle.

13. A method according to claim 1 , 11 or 12, wherein an additional parallel buckling line (1 2) is formed in the flat surface portion and the plate is also bent round the said additional buckling line (12) in order to change the angular shape of an additional portion (10c) of the flat surface portion (10a, 10a', 10b, 10c) of the plate (G), especially after shaping according to feature (c) of claim 1.

14. A method according to claim 13, wherein the two bent portions (10b, 10c) of the substantially flat surface portion are substantially parallel but spaced apart after the two bending operations.

15. A method according to claims 1, 13, 14 and 11, wherein after the buckling and bending processes the casing (100) is closed on at least four flat sides, especially after not more than three of the said buckling and bending processes.

16. A method according to claim 1 or 15, wherein the plate (G) is made substantially completely of sheet metal, and especially has functional openings (19, 19a).

17. A method according to claim 1, wherein the plate (G) is made of stiff plastics material but bendable at the buckling lines (11, 12, 13) and is covered by a metal covering, especially on the outside.

18. A method according to claim 1, wherein the plate (G, 10) is bent by hand after which the circuit board is stressed by force at the weakening line (31), likewise by hand.

19. A method according to any of the preceding claims, wherein integrally moulded plastics material parts, especially retaining parts for components, connecting members (K) for connecting bent (folded) portions of the plate, insulating members or similar surfaces or movable plastics material elements for fixing of components, project from the plate (G).

20. A method according to claim 1, wherein the bending or weakening line (31) of the circuit board is electrically bridged by a multi-core lead connection (35) which is flexible.

21. A method according to claim 1, wherein the substantially flat surface portion of the plate has an angle member (10a'), and the angle member connects two flat surface portions (10a, 10b) of the plate.

22. A method according to claim 21, wherein the buckling line (11) of the plate is situated in the angle member.

23. A method according to claim 1 , wherein the buckling or weakening line (31) of the circuit board is defined by short web portions which are appreciably shorter than the length of the weakening line.

24. A method according to claim 1, wherein the buckling line (11) in the substantially flat surface portion (10a, 10b) of the plate is defined by short web portions which are appreciably shorter than the length of the weakening line.

25. **A casing closed at a number of sides** and containing circuit boards (30; 31 a, 30b) for holding and electrically conducting components (60, 61, 62) mounted thereon, the casing being in the form of a power electronics device (100), especially a converter, **produced by at least one method** according to the preceding claims, wherein
(a) a circuit board (30) already fitted with components is mounted in an open assembly on a substantially flat surface portion (10a, 10b, 10c, 10a') of a plate or side (G, 10) of the casing;
(b) the circuit board has at least one weakening line (31) parallel with a buckling line (11) in the substantially flat surface portion of the plate;
(c) at the buckling line (11) the plate (G, 10) is bent into an angular shape (10a, 10b), when the weakening line (31) of the circuit board is also subjected to bending forces,
the circuit board (30) being bent and broken into two pieces (30a, 30b) at an angle to one another to form the power electronics device (100).

26. A casing closed on a number of sides and containing circuit boards (30; 30a, 30b) according to claim 25, with a number of the said buckling lines (11) and weakening lines, in each case disposed in pairs.

## Revendications

1. Procédé de fabrication d'un boîtier fermé sur plusieurs côtés comme appareil (100) d'électronique de puissance, en particulier d'un convertisseur, avec des platines (30 ; 30a, 30b) qui y sont agencées pour le maintien et la connexion électrique de composants (60, 61, 62) aménagés par-dessus, dans lequel :
(a) une carte de circuits imprimés (30) déjà pourvue de composants est montée en montage ouvert sur une section de surface sensiblement plane (10a, 10b, 10c, 10a') d'une plaque de boîtier (G, 10) ;
(b) la carte de circuits imprimés présente au moins une ligne de pliage ou d'affaiblissement (31), qui s'étend parallèlement à une ligne de pliage (11) dans la section de surface sensiblement plane de la plaque de boîtier ;
(c) la plaque de boîtier (G, 10) est repliée sur la ligne de pliage (11) pour conférer une forme angulaire (10a, 10b) et, en l'occurrence, la ligne de pliage ou d'affaiblissement (31) de la platine est également sollicitée par des forces de pliage ou de flexion,
pour replier la platine (30) et la rompre en deux pièces (30a, 30b) orientées en faisant un angle l'une par rapport à l'autre.

2. Procédé selon la revendication 1, dans lequel la forme angulaire est sensiblement perpendiculaire (10a, 10b) à la fin de l'opération de flexion.

3. Procédé selon la revendication 1, dans lequel la platine (30) se présente sous une forme plane et non fractionnée lors de son montage sur la section de surface sensiblement plane de la plaque de boîtier (G).

4. Procédé selon la revendication 1, dans lequel la platine (30) est montée de manière flottante (40 ; 41 à 44) lors de son montage sur la section sensiblement plane pour compenser des tolérances ou des suites de la sollicitation à la flexion.

5. Procédé selon la revendication 1, dans lequel on intercale une couche isolante (20) entre la platine (30) et la plaque de boîtier (10, G).

6. Procédé selon la revendication 1, dans lequel la ligne de pliage ou d'affaiblissement (31) de la platine se présente sous une forme à forces réduites.

7. Procédé selon la revendication 6, dans lequel la platine (30) présente plusieurs évidements espacés dans la zone de la ligne de pliage ou d'affaiblissement pour réduire la longueur continue de la ligne de pliage ou d'affaiblissement (31).

8. Procédé selon la revendication 1, dans lequel la ligne de pliage se présente sous une forme à force de flexion réduite dans une section plane.

9. Procédé selon la revendication 8 ou 1, dans lequel la ligne de pliage (11) de la plaque de boîtier (G) est formée de métal ou d'un matériau synthétique.

10. Procédé selon la revendication 1 ou 9, dans lequel on peut replier la plaque de boîtier (G) plusieurs fois sur plusieurs lignes de pliage (11, 12) s'étendant de manière sensiblement parallèle.

11. Procédé selon la revendication 1, dans lequel une section (10d) de la plaque de boîtier est déjà préalablement repliée en s'écartant d'un certain angle lors du montage de la carte de circuits imprimés (30) sur la section sensiblement plane, ledit repliage préalable s'étend autour d'une ligne de pliage (13) située entre la section plane (10a, 10a', 10b, 10c) et la section (10d) s'écartant d'un certain angle.

12. Procédé selon la revendication 1, dans lequel la section (10d) s'écartant d'un certain angle se déplace avec le pliage de la platine et la section plane de la plaque de boîtier, mais n'est pas également déformée.

13. Procédé selon la revendication 1, 11 ou 12, dans lequel une autre ligne de pliage (12) s'étendant parallèlement est aménagée dans la section de surface plane et la plaque de boîtier est également recourbée autour de cette autre ligne de pliage (12), pour effectuer une déformation angulaire d'une autre section (10c) de la section de surface plane (10a, 10a', 10b, 10c) de la plaque de boîtier (G), en particulier après déformation selon la caractéristique (c) de la revendication 1.

14. Procédé selon la revendication 13, dans lequel les deux sections recourbées (10b, 10c) de la section de surface sensiblement plane s'étendent, après les deux déformations, sensiblement parallèlement l'une à l'autre, mais à distance l'une de l'autre.

15. Procédé selon la revendication 1, 13, 14 et 11, dans lequel le boîtier (100) est fermé sur au moins quatre côtés de surface après les opérations de pliage et de flexion, en particulier après pas plus de trois des opérations de pliage et de flexion mentionnées.

16. Procédé selon la revendication 1 ou 15, dans lequel la plaque de boîtier (G) est formée de manière sensiblement complète d'une tôle métallique et présente en particulier des ouvertures fonctionnelles (19, 19a).

17. Procédé selon la revendication 1, dans lequel la plaque de boîtier (G) est constituée d'un matériau synthétique rigide, mais flexible sur les lignes de pliage (11, 12, 13), et est recouverte d'un revêtement métallique tourné en particulier vers l'extérieur.

18. Procédé selon la revendication 1, dans lequel la flexion de la plaque de boîtier (G, 10) et la sollicitation de la platine aux forces qui en résulte se font sur la ligne d'affaiblissement (31) à la main.

19. Procédé selon l'une quelconque des revendications précédentes, dans lequel des pièces de matériau synthétique moulées par injection s'écartent de la plaque de boîtier (G), en particulier des pièces de soutien pour des composants, des pièces de raccordement (K) pour raccorder des sections recourbées (repliées) de la plaque de boîtier, des pièces isolantes ou des surfaces de ce genre ou encore des éléments mobiles en matériau synthétique pour fixer des composants.

20. Procédé selon la revendication 1, dans lequel la ligne de pliage ou d'affaiblissement (31) de la platine est pontée par conduction électrique par un faisceau de conduction à fils multiples (35), qui est conformée de manière flexible.

21. Procédé selon la revendication 1, dans lequel la section de surface sensiblement plane de la plaque de boîtier présente une pièce coudée (10a') et cette pièce coudée raccorde deux sections de surface planes (10a, 10b) de la plaque de boîtier.

22. Procédé selon la revendication 21, dans lequel on aménage la ligne de pliage (11) de la plaque de boîtier dans la pièce coudée.

23. Procédé selon la revendication 1, dans lequel la ligne de pliage ou d'affaiblissement (31) de la carte de circuits imprimés est définie par de courtes sections de moulures, qui sont sensiblement plus courtes que la longueur de la ligne d'affaiblissement.

24. Procédé selon la revendication 1, dans lequel la ligne de pliage (11) est définie dans la section de surface sensiblement plane (10a, 10b) de la plaque de boîtier par de courtes sections de moulure, qui sont sensiblement plus courtes que la longueur de la ligne d'affaiblissement.

25. Boîtier fermé sur plusieurs côtés avec des platines qui y sont agencées (30 ; 30a, 30b) pour un maintien et une connexion électroconductrice de composants (60, 61, 62) aménagés par-dessus comme appareil (100) d'électronique de puissance, en particulier comme convertisseur, qui est ou peut être fabriqué selon au moins un procédé des revendications précédentes, dans lequel :
(a) une carte de circuits imprimés (30), déjà pourvue de composants, est montée en montage ouvert sur une section de surface sensiblement plane (10a, 10b, 10c, 10a') d'une plaque de boîtier (G, 10) ;
(b) la carte de circuits imprimés présente au moins une ligne d'affaiblissement (31), qui s'étend parallèlement à une ligne de pliage (11) dans la section de surface sensiblement plane de la plaque de boîtier ;
(c) la plaque de boîtier (G,10) est repliée sur la ligne de pliage (11) pour lui donner une forme angulaire (10a, lOb) et, en l'occurrence, la ligne d'affaiblissement (31) de la platine est également sollicitée par des forces de flexion,
tout en repliant et en rompant la platine (30) en deux pièces (30a, 30b) orientées sous une forme angulaire l'une par rapport à l'autre et en formant l'appareil (100) d'électronique de puissance.

26. Boîtier fermé sur plusieurs côtés avec des platines qui y sont agencées (30; 30a, 30b) selon la revendication 25, ayant plusieurs des lignes de pliage (11) et des lignes d'affaiblissement mentionnées, qui sont ou ont été affectées l'une à l'autre respectivement par paire.
